# EUROPEAN PATENT SPECIFICATION

(11) **EP 0 447 411 B1**
(45) Date of publication and mention of the grant of the patent: **17.07.1996**
(21) Application number: 89912892.0
(22) Date of filing: 30.11.1989
(51) Int. Cl.: H03J 7/16, H03L 7/06

(54) **A METHOD AND A DEVICE PERTAINING TO AN ELECTRO-MECHANICALLY CONTROLLED RESONANCE MODULE**
VERFAHREN UND ANORDNUNG, DIE SICH AUF EIN ELEKTROMECHANISCH GESTEUERTES RESONANZMODUL BEZIEHEN
METHODE ET DISPOSITIF CONCERNANT UN MODULE DE RESONANCE A COMMANDE ELECTRO-MECANIQUE

(30) Priority: 02.12.1988 SE 8804374; 06.10.1989 SE 8903298
(43) Date of publication of application: 25.09.1991
(73) Proprietor: ALLGON AB, S-184 25 Akersberga (SE)
(72) Inventor: SALDELL, Ulf, S-184 51 Österskär (SE)
(74) Representative: Billberg, Hans
(86) International application number: PCT/SE89/00705
(87) International publication number: WO 90/06627

(56) References cited:
- EP-A- 0 012 656
- US-A- 3 271 684
- US-A- 4 726 071

## Description

The present invention relates to a method, for use in mobile telephone systems which include: a base station comprising:
- a plurality of resonance modules in the form of cavity resonators for separately adjusting each of said resonance modules to its own frequency for receiving and expediting telephone signals on this frequency,
- tuning means in each resonance module which is guided to a given resonance position in relation to the frequency of signals fed to the module,
- electromechanical drive means for operating the tuning means;
   wherein for each of said cavity resonators
- a specific input signal to the base station is used as a reference signal, fed to the cavity resonators and made available for detection at the input of the cavity resonators, and
- a measuring signal is made available for detection at the output of the cavity resonator. The invention also relates to apparatus for carrying out the method, and a method in using the method.

In such mobile telephone systems it is already known from US-A-3 271 684 a base station including tuning means for adjusting a resonator to a given resonance position in relation to the frequency of incoming signals, wherein the tuning means of the resonator is operated by an electro-mechanical drive means which is connected to obtain a drive voltage via a phase comparison means, said phase comparison means being formed such that the drive voltage passes solely when the input signals fed to the phase comparison means differ in phase, a signal line carrying a signal branched from an input signal to the resonator being connected to the phase comparison means, a signal line carrying the output signal from the resonator;
such that when both signals are in phase the drive voltage is zero, the drive means is stationary, and the tuning means has set the resonator in resonance with the input signal.

From EP-A-012 656 there is known a cavity resonator which is tuned via motor drive.

The present invention has the object of improving the automatic adjustment and, inter alia, there is achieved with the invention that a part of the switching circuit functions as a selective amplitude detector, resulting in that the apparatus will not be responsive to signals from neighbouring channels. With the aid of the circuits and the electro-mechanical adjusting means there is achieved a very rapid setting and fine adjustment of the resonance module in question. The rapidity of the setting means is in itself necessary in telephone systems, and was perhapse afforded by earlier known setting means as well, but in addition the setting means in accordance with the present invention is much more reliable and has a long life.

The characterizing features of the present invention are apparent from the following claims, and the invention will now be described in more detail and with reference to the acompanying Figures, where,

Fig. 1 is a block diagram of units included in the system for the adjustment of the resonace modules.

Fig. 2 is a circuit diagram of three detectors included in the system.

Fig. 3 is a graph of the phase setting.

Fig. 4 is a circuit diagram of the error amplifier.

Fig. 5 is a circuit diagram of the error amplifier signal paths when the transmitter is turned off.

Fig. 6 illustrates the signal paths for the error amplifier during searching.

Fig. 7 is a circuit diagram of the error amplifier signal paths.

Fig. 8 is a circuit diagram for switching lodgic.

Fig. 9 is a cross section through a resonance module and adjusting means in accordance within the invention.

Fig. 10 schematicly illustrates the system in accordance with the invention.

The method of controlling the setting means for the resonance module in accordance with the invention will now be summeraly described without specific reference to the drawing figures.

A measuring signal is taken out of either side of a resonance module, one signal being taken out before the module and the other signal after it. Hereinafter the formar signal is designated "reference signal" and the latter" measuring signal". A first detector senses the reference signal and delivers a voltage. If the associated antenna is not picking up any input signal there is no reference signal, which can be applied to the resonance module and there is thus no voltage either. If, on the other hand a reference signal arrives to the resonance module then a measuring signal always occurs sooner or later on the other side (output) of the module, and this signal - the measuring signal - is detected by a second detector. The detector has a control circuit, and this is switched to search state, signifying that the module tuning means performs a movement in the module and corresponding measuring signal is sent. When the reference signal and measuring signal have the same phase angle, there is obtained a maximum potential between two applied voltages, which are controlled by the second detector. When there is no measuring signal, the applied voltage has no potential difference. A third detector is now arranged for measuring said phase difference between the reference signal and measuring signal, suitably such that either the reference signal or the measuring signal is phase shifted 90° in relation to the other signal so that an auxiliary signal is obtained. A voltage fed to the circuit will change in size and strength, but due to the phase difference this voltage will be zero in case where there is 90° phase difference between these signals. One then also knows that there is a phase agreement between the reference signal and measuring signal. By searching specificly for a zero point in the voltage differences and not a maximum point, makes it possible to obtain a more exact position by achieving a phase difference between the reference signal and measuring signal and using the auxiliary signal thus generated for finding out when phase equality is present. A phase error between the reference and measuring signals gives rise to a proportionally positive or negative error voltage, which after suitable amplification is used to control the adjusting means so that the error goes towards zero.

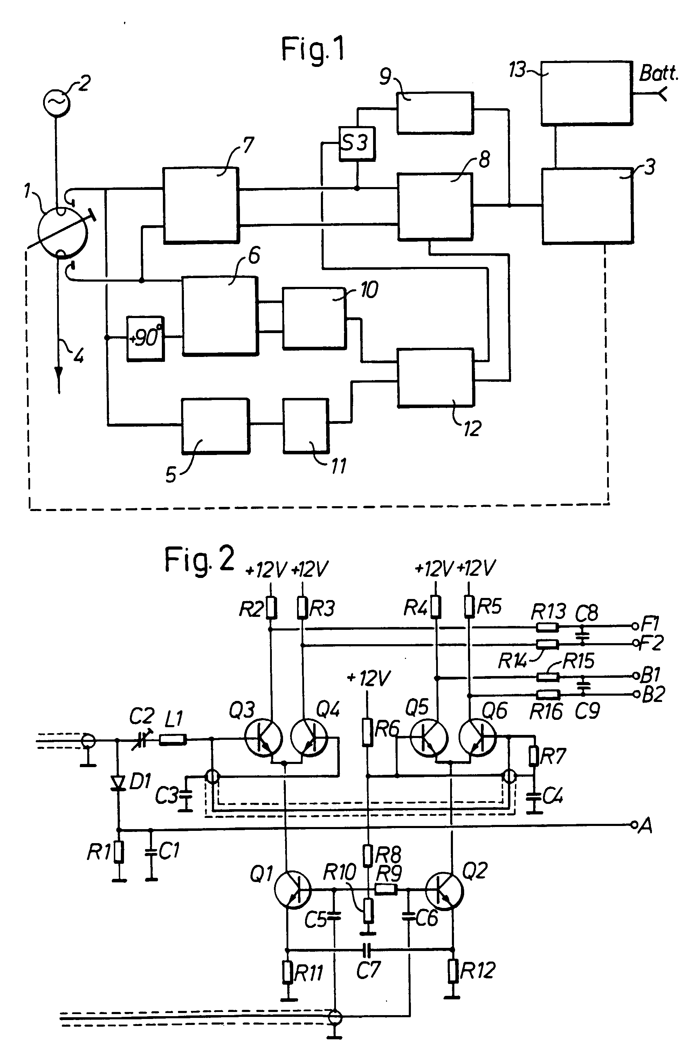

The apparatus in accordance within the invention is illustrated schematically with the aid of a block diagram in Fig. 1. The base station has a plurality of resonance modules. Each module has its own electrical control circuit and its own adjusting means. In Fig. 1 there is illustrated the resonance module 1 which has a setting means 3, which reciprocates a tuning means to and from in the resonance module until the tuning means has reached the position where resonance occurs in the module between an input signal and an output signal. The input signal is thus a signal picked up by an antenna and which is to be taken further to a telephone for establishing communication. Hereinafter the incoming signal is designated "reference signal" and arrives to the resonance module via an antenna. When the tuning means has set the resonance module to its resonance state, the output signal from it, is equal in frequency with the input signal and can be sent further for telecommunication. Three detectors are arranged for giving signals for operating the setting means 3 via amplified signals. The first detector is denoted by the numeral 5 and senses the reference signal, and if there is no such signal, no voltage will be sent, signifying that no signal reaches the setting means 3. The detector 5 is connected to a comparator 11, a logic curcuit 12 and further to both an error amplifier 8 and a search amplifier 9. A second detector is denoted by the numeral 6 and is designated "amplitude detector". This detector obtains signals in the form of a reference signal and a measuring signal, i.e. the signals taken out before and after the resonance module. The signals from the amplitude detector go via a comparator and a logical circuit to the search amplifier 9. A third detector is denoted by the numeral 7 and designated "phase detector". This detector similarly obtains signals in the form of the reference signal and the measuring signal, and these signals are compared and taken to the error amplifier 8. The voltage supply to the apparatus takes place from a battery via a voltage regulator 13.

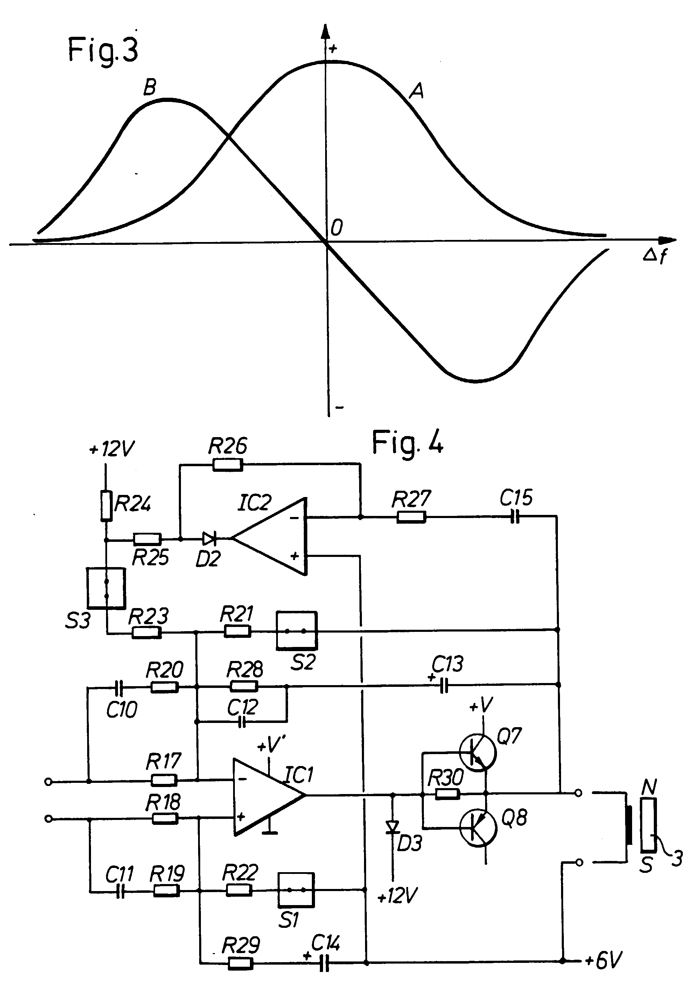

The function of the three detectors will now be described with reference to the Figs. 2 and 3. In the circuit diagram of Fig. 2 it will be seen that three detectors are formed round the diod D₁ and the transistors Q₁-Q₆, these three detectors being necessary for controlling the associated resonance module in all situations in order to obtain the resonance frequency at which its transmitter operates. Two signals are required: The first one is a reference signal, which is taken out from a point directly before the resonance module, possibly via a direction coupler. A suitable signal level can be said to be about 1 mW. A second signal which, in the following, is thus designated the "measuring signal" is taken down from a point after the resonance module, but before its connection with the other modules in the station. A direction coupler is necessary so that inter mixture with other channels will be as small as possible. A suitable level for the measuring signal is also about 1 mW.

If the transmitter is closed down, no searching or frequency adjustment of the resonance module shall be carried out. The first detector comprices D₁, R₁ and C₁ and gives a voltage at the point A of a minimum of 50 mW when the transmitter is in operation. When the transmitter is closed down the voltage is 0 volt. A time constant R₁, C₁ is selected such that an indication of interrupted transmission can take place for less than 0,5 ms.

The second detector includes the transistors Q₂, Q₅ and Q₆.

When transmission is in progress, but there is no measuring signal, the control circuit must be set in the search mode. Sooner or later a measuring signal will be detected by a detector 2. The output signal will be between the point B₁ and B₂. This signal is used to stop the searching sequence and initiates a fine adjustment of the resonance module, i.e. to its cavity resonance frequency. The illustrated circuit functions as a selective amplitude detector and is therefore not responsive to signals of the neighbouring channels. A suitable working point for the transistors Q₁-Q₆ is adjusted with the aid of the resistances R₆, R₈, R₁₀, R₁₁ and R₁₂. The illustrated capacitors C₃, C₄ and C₅ are effective HF decoupling capacitors. The measuring signal is supplied to Q₂ and arrives at its base via the coupling capacitor C₆. The resistor R₉ terminates the feed cable leading the measuring signal with the right impedance to the transistor Q₁. The measuring signal is regained in an amplified state at the collector of the transistor Q₂. This collector current is devided between R₄ and R₅ depending on how the transistors Q₅ and Q₆ are controlled. The reference signal passes the filter C₂. L₁ and is taken via a short cable to the base of the transistor Q₆. The resistor R₇ terminates the cable with the right impedance. The reference signal conducts the transistors Q₅ and Q₆ alternatively. If both the reference and the measuring signals have the same phase angle, all current pulses through the transistor Q₂ will be connected to the resistor R₅, with the result that B₁ will be given a high potential while B₂ will be given av low potential.

As will be understood from the description so far an equal voltage of +12 volt will be fed across the parallel resistors R₄ and R₅. If there is no measuring signal, the transistors Q₅ and Q₆ will conduct the same current alternately and the voltage drops across the resistors R₄ and R₅ will be equal. There will not be any voltage difference between B₁ and B₂ either. This is illustrated in figure 3 by the graph A.

The resistors R₁₅ and R₁₆ as well as the capacitor C₉ form a lowpass filter which takes away all remnants of HF from the detector circuit. For the proper function, the requirement of correct phase angle between the reference signal and the measuring signal is important. This is arranged in the first place by the cables for the respective signals being given a specific length. Fine adjustment then takes place with the capacitor C₂ which with the aid of L₁ can turn the phase about +45°.

When the search according to the above has been stopped with the aid of the detector two, a third detector takes over and controls the tuning means of the resonance module so that the resonance frequency always agrees with the transmitter signal and so that the least possible damping of it is obtained. This third detector is formed by the transistors Q₁, Q₃ and Q₄, which mainly measure the phase difference between the reference and measuring signals. The graph B in figure 3 illustrates the phase sequence as a function of the frequency. Correct tuning takes place when the voltage difference between the F₁ and F₂ is 0 volt. The working point for the transistors in the third detector is determined in the same way and by the same components as for the detector 2. The balanced transistor pair Q₃ and Q₄ is fed with the reference signal, which is here arranged to be at 90° in front of the signal in the detector two. The cable between the detectors is a quarter of a wavelength long, which gives a phase shift of 90°. The measuring signal, which is amplified in the transistor Q₂, is connected via the capacitor C₇ and transistor Q₁ and appears at its collector shifted 180° in relation to its phase position at the transistor Q₂.The current pulses from the transistor Q₁ are divided by the 90° phase difference equally between the transistor Q₃ and the transistor Q₄. The consequence of this is that the voltage drops across the resistors R₂ and R₃ will be equal and the output voltage between F₁ and F₂ will be zero volts. It will be understood that in the same way as for the signals at B₁ and B₂ each of the parallel resistors R₁ and R₂ is fed with equal voltages of +12 volt. The resistors R₁₃ and R₁₄ as well as the capacitor C₈ take away the residues of HF and interference signals caused by the neighbouring channels. A phase error between the reference and measuring signals gives rise to a portional positive or negative error voltage, which after suitable amplification is used to control the tuning means in the resonance module so that the error or difference in phase goes towards zero. The capacitor C2 is used in practice to adjust the entire system to obtain the best tuning result.

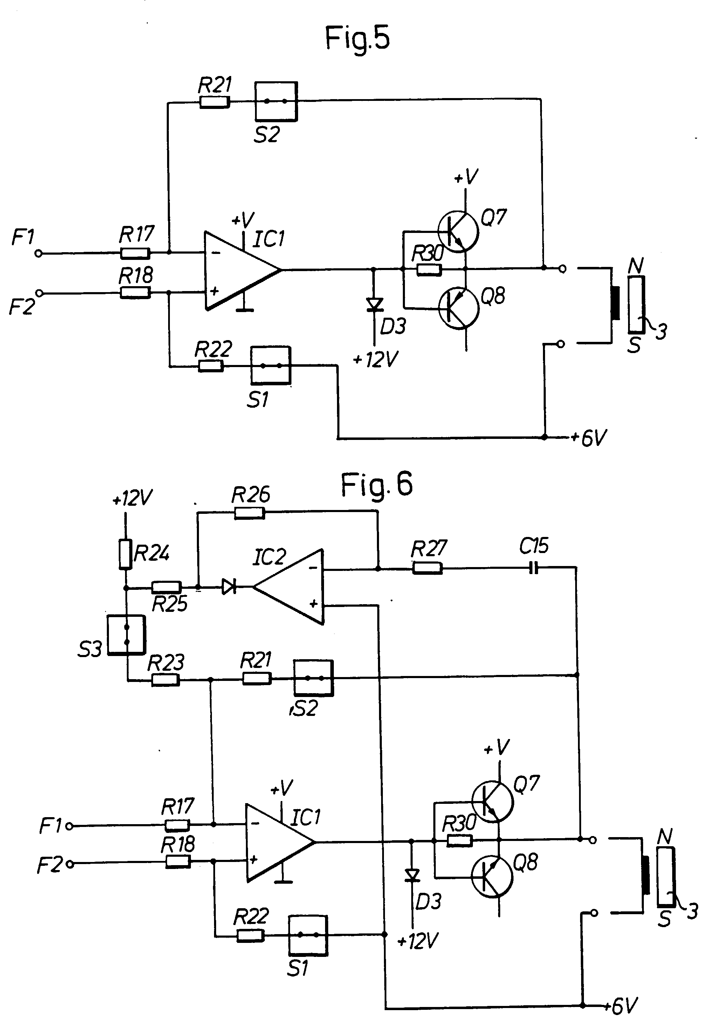

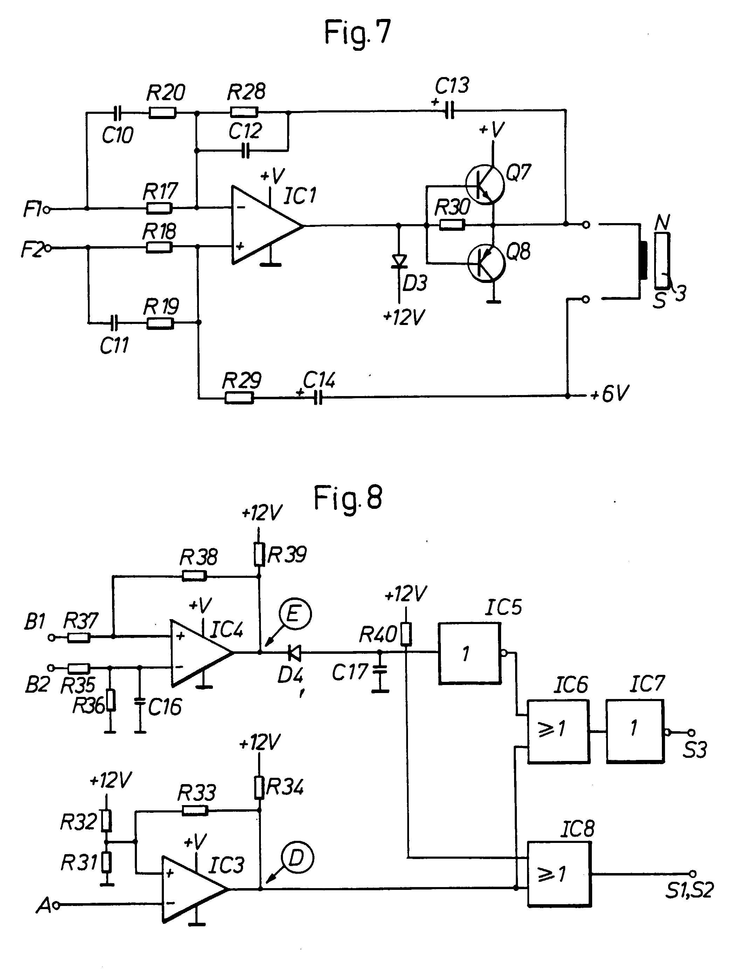

As mentioned above, a suitable amplification of the signals from the detectors is arranged to provide the drive to the adjusting means. A terminal drawing of an examplification of an error amplifier is to be found in figure 4. As will be understood, the circuit of figure 4 is connected to that in figure 2 at the points F₁ and F₂. Accordingly, the amplifier circuit according to figure 4 caters for the signals from the detectors at points F₁ and F₂ and with the aid of the adjusting means 3 pulls or pushes the tuning means in the resonance module to its proper position for achieving resonance. The operational speed of the tuning means is a function of the voltage which the amplifier feeds to the winding of the adjusting means. In the proposed solution, a stable 6-volt potential is used as a reference voltage for the error amplifier circuit and the adjusting means. This voltage is obtained from the voltage regulator 13, see figure 1. A final step is formed by the transistors Q₇ and Q₈ and has an amplification of one and is capable of supplying all current required by the adjusting means. The error amplifier can operate in three different modes depending on the character of the output signals from the two detectors. A logic for the switching is described later, but first there will now be described the different signal paths for the different modes, and with reference to figure 5, 6 and 7. Mode 1 signifies that the transmitter is shut down and is described in connection with figure 5. Mode 2 signifies that searching is being carried out by the signal and is described in the following together with figure 6. Mode 3 signifies that the signals are being supervised and will be described in connection with figure 7. Switching takes place by three analogue switches S₁, S₂ and S₃, see figure 4.

Figure 5 thus shows the signal path in mode 1, i.e. with the transmitter shut down. In this state the adjusting means never moves, i.e. the tuning means is not allowed to move and consequently the adjusting means is never fed with any voltage. If the resistors R₂₁/R₁₇ are in the same relationship as the resistors R₂₂/R₁₈ and the voltage between F₁ and F₂ is zero, this condition is met. An operation of amplifier IC₁ has a high differential amplification and high supression of asymmetrical voltages. If the amplification of the error amplifier is low, R₂₁/R₁₇ <<1, a minor residue voltage between F₁ and F₂ can be tolerated due to the friction in the adjusting means. This friction can also be desirable for keeping the adjusting means resistant to small mechanical vibrations.

Mode 2, the signal searching mode, has its signals illustrated in figure 6. During searching, the tuning means must be driven at a constant rate from one end position to the other and back again. A pneumatic damper, which is built into the adjusting means, garantees a suitable rate at the right voltage across the adjusting means. This voltage changes polarity when the direction is changed. Figure 6 thus illustrates a possible solution to the drive problem. An operational amplifier IC₂ is arranged, and is of the same type as the operational amplifier IC₁ according to figure 5, and amplifies the signal across the adjusting means via a capacitor C₁₅ and a resistor R₂₇. The signal is re-fed in positive phase to the input of the operational amplifier IC₁. The result is an oscillator, with a frequency determined by the capacitor C₁₅, resistor R₂₆ and the amplitude across the adjusting means. In turn, the amplitude is determined by the resistors R₂₄,R₂₅,R₂₃ and R₂₁. Mode 3 is the mode relating to accompanying the signal, and is thus illustrated in figure 7. When the second detector senses a signal of the right kind, the circuit round the operational amplifier IC₁ is immediately changed in accordance with what is shown in figure 7. It is then possible for the signal from the second detector between F₁ and F₂ to pass through the error amplifier and feed the adjusting means 3 in a phase such that the plunger movement is stopped. A fine adjustment of the position takes place so that the voltage between F₁ and F₂ goes towards zero. It is first here that the circuit justifies its designation of error amplifier. It should be observed that the capacitors C₁₃ and C₁₄ constitute an interruption for direct current so that the voltage between F₁ and F₂ is amplified in the long run by the entire amplification of the operational amplifier IC₁, this amplification being about 100.000 times. The components C₁₀,C₁₁,R₁₉,R₂₀,C₁₂,R₂₈, R₂₉, C₁₃ and C₁₄ give a suitable amplitude and phase sequence for different sequences enabling the circuit according to figure 7 to be stable in all situations. The values of the components are determined by a series of factors i.e. the total weight of the tuning means, its tuning range relative its motion, friction, the power of the adjusting means for a given applied voltage, the phase sequence of the resonance cavity, the sensitivity of the detector 3 etc.

There is also a logical switching circuite for switching between the three previously mentioned modes. The signals from the detectors one and two must namely be converted to logical levels which are to control the switches S₁,S₂ and S₃. A possible circuit of components for this purpose is illustrated in figure 8. Accordingly, there are two operational amplifiers IC₃ and IC₄ and these have peripheral components functioning as decision makers for the respective signal. Levels as well as hysteresis are determined by the components round each circuit. At the points D and E, the different signal states can be read off in the form of logical l's and 0's (high and low level). The operational amplifiers IC₅ and IC₆, IC₇ and IC₈ convert the signals at D and E according to figure 8 to signals for the switches S₁, S₂ and S₃. The components D₄,R₄₀ and C₁₇ form a delay circuit preventing searching from starting once again for a short overcorrection, i.e. when capturing. The switches are on when the control voltages are high, i.e. they are 1's.

| TABLE OF LEVELS IN THE SWITCHING LOGIC | | | | | |
|---|---|---|---|---|---|
| Mode | D | E | E for DR | S₁,S₂ | S₃ |
| Output carrier wave | 1 | 1 | 1 | 1 | 0 |
| Searching | 0 | 1 | 1 | 1 | 1 |
| Accompanying | 0 | 0 | 0 | 0 | 0 |
| Overcorrection | 0 | 1 | 0 | 0 | 0 |
| Carrier wave off | 1 | 1 | 0 | 1 | 0 |

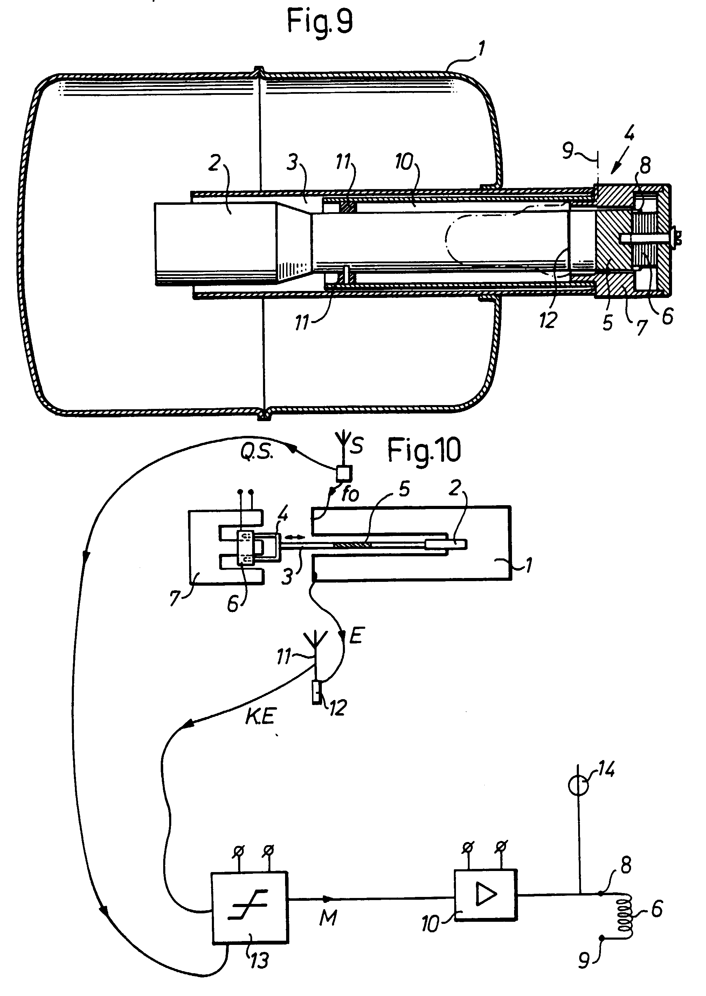

Figure 10 primarily illustrates a resonance module 21. The module contains a cavity with a tuning means 22. Resonance is obtained when the tuning means has adjusted the cavity natural frequency into agreement with an input signal to the cavity. The tuning means 22 is thus moved reciprocally in the cavity in response to which desired natural frequency for the resonance module. Operation of the tuning means 22 takes place by a rod 23 connected to an electromechanical device, which in this case comprises an electromagnet 27 and a coil 26 round the core of the electro magnet. The rod 23 is connected via a stirrup 24 to the coil. The rod has an insulator 25 separating the rod and thus the drive means from the tuning means 22. The coil 26 has two electrical terminals. The tuning means 22 has the form of a metal tongue, e.g. of copper or silver-plated copper and it moves reciprocally in the cavity, which will thus be tuned to different frequencies for different positions of the tuning means in it. An input signal to the cavity results in an output signal at the same frequency as soon as the natural frequency or resonance frequency of the cavity is equal to that of the input signal.

A servoamplifier 30 sends operation signals to the drive means i.e. to the coil 26 via the terminals 18 and 19. This has been illustrated schematically in figure 10 at the bottom to the right. The control current for the motor is formed by the voltage at its terminals, and this voltage can have different potentials or be plus or minus. As soon as the voltage changes or plus is changed to minus, the moving coil 26 will change position and thereby move the rod 23 and metal tongue in the cavity. The servoamplifier 30 is fed by a current with a changing character in response to an input signal M to the servoamplifier. This signal M is generated as explained below.

The output signal E from the resonance module goes to a sensing means 32 and further to an antenna 31. The output signal from the sensing means is a signal KE, which is a constant times E, and this signal is taken to a phase comparison means 33. This means operates at a radio frequency of 900 MHz or 450 MHz. Variations of these frequences are considerable. A signal QS branched off from the input signals S is also taken to the phase comparison means 33. The phases of the signals KE and QS are compared in the phase comparison means 33 which sends the signal M as long as phase difference is present. The signal M is converted in the servoamplifier 30 to control current (voltage) which drives the electrical mechanical drive means 26,27, which in turn moves the tuning means 22 in the cavity in the resonance module 21. The phase of the output signal KE will thus be changed and the comparison between the signals KE and QS follow the lower graph in figure 2. When the phase difference is zero, there is resonance in the resonator and the output signal is at a maximum. There is no output signal M from the phase comparison means and the drive means 26,27 stops and the tuning means 22 has arrived at the tuned-in position.

A preferred embodiment of an adjusting means for the tuning means will now be described in connection with figure 9. The tuning means includes a chamber 41 with a tuning means 42 in the form of a metal plunger which is reciprocally movable in a cylinder chamber 43. The plunger 42 is moved with the aid of a means 44. This means comprises a centrally situated iron core 45 in connection with a permanent magnet 46. Outside the iron core and permanent magnet there is an iron ring 47 concentric with these parts and having an annular gap between it and them. An electricly insulating sleeve 48 is reciprocally displacable round the iron core 45 and carries a winding. The winding is fed with current via a very flexibel long wire 49 which is not effected by the displacement of the sleeve 48. In the illustrated embodiment, the metal plunger 42 is carried by an extension 50 of the sleeve 48. The extension is mounted on support cushions 51, e.g. of nylon, and these are situated in the region of the central gravity for the system comprising metal plunger, plunger shank and iron core.

In the vicinity of the iron core 45 there is inserted a disc 52, thus forming an air space constituting a damping volume for the resiprocating movement of the sleeve about the iron core 45. The sleeve part 50 can be regarded as a piston rod which can be formed from high frequence-insulating material. Alternatively it can be made from aluminium and the iron core 45 is then preferably quoted with teflon. The wire 49 supplies voltage to the winding for the purpose of driving the sleeve 48 in either direction on the iron core 45 and for achieving a resonance position for no voltage, when the adjusting means is then inmoveable. The arrangement has the advantage that the adjusting means operates rapidly and the moving parts have low mutual friction.

The invention also relates to a method of periodacly increasing the number of available frequencies in a base station. Each base station is then equipped with more resonance modules than the number corresponding to the number of necessary frequencies for normal or low telephone traffic at the base station for a given period of time. Each resonance module is tunable to the input signal by the tuning means moving in a cavity in the resonance module. If now the number of frequencies of a given base station needs to be increased due to increasing local traffic intensity, the unoccupied module is tuned to frequencies which are not required in another or other base station within the area and for the period of time covering the time with increased intensity of the base station in question. When the traffic intensity of the base station in question declines again, the frequencies are then returned to another or other base station to suite the requirements of the traffic intensity. Tuning is carried out in accordance with the method already described.

By this procedure of loaning out frequencies from different base stations to other base stations there is thus provided the possibility, i.e. in a town area, to let the base station in the center of the town area having most of the frequencies during the day time, and many more than individual base stations outside the central area. During the early morning and evening, the base stations in the outer area of the town area require more frequencies to meet the traffic intensity, and frequencies are then transformed from the base station in the town area center to resonance modules in base stations in the outer areas of the town area. What is required for being able to carry this out is thus that radio signals are used which each give a resonance module notification of what frequency it is to have and that tuning of the resonance module in question can take place rapidly for coming into an agreement with the input signal. The tuning means of the resonance module must thus be operated by a very rapid motor. Such a motor has been described in connection with Fig. 9.

## Claims

1. Method for use in mobile telephone systems which include: a base station comprising:
- a plurality of resonance modules in the form of cavity resonators for separately adjusting each of said resonance modules to its own frequency for receiving and expediting telephone signals on this frequency,
- tuning means in each resonance module which is guided to a given resonance position in relation to the frequency of signals fed to the module,
- electromechanical drive means for operating the tuning means;
wherein for each of said cavity resonators
- a specific input signal to the base station is used as a reference signal, fed to the cavity resonators and made available for detection at the input of the cavity resonators, and
- a measuring signal is made available for detection at the output of the cavity resonator,
**characterized in** comprising the steps of:
- detecting the reference signal;
- producing a first control signal which is at a positive output voltage when said reference signal is present, and which is zero when said reference signal is not present, and which determines whether or not, respectively, said tuning means is supplied with a voltage which activates said drive means;
- detecting the amplitudes of said reference signal and said measuring signal, and,
- if the amplitudes are not equal and said first control signal is at the positive output voltage, activating said drive means in a search mode to scan the resonance module throughout its range of resonance frequencies,
- if the amplitudes are equal before or during said scan, deactivating said drive means;
- detecting the phase difference between the reference and the measuring signal, and correspondingly producing a voltage reactivating said drive means such that the phase of said measuring signal is changed towards the phase of the reference signal.

2. Method as claimed in claim 1, wherein the phase difference between said measuring signal and the reference signal is determined in that either one of the measuring signal and the reference signal is given a phase difference of 90° to form an auxiliary signal, whereby when the phase between the auxiliary signal and the signal with the unchanged phase is zero no signal is sent for driving the adjusting means.

3. Apparatus for use in mobile telephone systems which include:
a base station comprising:
- a plurality of resonance modules in the form of cavity resonators for separately adjusting each of said resonance modules to its own frequency for receiving and expediting telephone signals on this frequency,
- tuning means in each resonance module which is guided to a given resonance position in relation to the frequency of signals fed to the module,
- electromechanical drive means for operating the tuning means;
wherein for each of said cavity resonators
- a specific input signal to the base station is used as a reference signal, fed to the cavity resonators and made available for detection at the input of the cavity resonators, and
- a measuring signal is made available for detection at the output of the cavity resonator,
**characterized in**:
- means (5) for detecting the reference signal;
- means for producing from the reference signal a control signal which is at a positive output voltage when said reference signal is present, and which is zero when said reference signal is not present, and which determines whether or not, respectively, said tuning means is supplied with a voltage which activates said drive means (3);
- means (6) for detecting the amplitudes of said reference signal and said measuring signal, said means operating such that:
- if the amplitudes are not equal and said control signal is at the positive output voltage, activating said drive means in a search mode to scan the resonance module throughout its range of resonance frequencies,
- if the amplitudes are equal before or during said scan, deactivating said drive means;
- means (7) for detecting the phase difference between the reference and the measuring signal, and correspondingly producing a voltage reactivating said drive means such that the phase of said measuring signal is changed towards the phase of the reference signal.

4. Apparatus as claimed in claim 3, **characterized in** that the third detector comprises means (Q₃,Q₄) for phase-shifting by 90° either the signal from the receiving side of the cavity resonator or the signal from the transmitting side of the cavity resonator.

5. Apparatus as claimed in claim 3, **characterized** in that the first detector includes a diode (d₁) connected to the receiving side of the cavity resonator, and including a resistor (R₁) and a capacitor (C₁) on the other side of the diode, the resistor (R₁) and the capacitor (C₁) having ends connected to ground.

6. Apparatus as claimed in claim 3, **characterized** in that the second detector includes first transistor (Q₂) having a base connected to an input of the measuring signal via a coupling capacitor (C₆) to reach a collector of the transistor, a second transistor (Q₆) and a third transistor (Q₅) having bases which are connected in parallel to an input of said reference signal via a filter (C₂, L₁) and a short cable, an equal voltage being fed in parallel to collectors of said second and third transistors (Q₅,Q₆), a voltage from each collector being taken off via a resistor (R₁₅,R₁₆), said first transistor (Q₂) being connected by the collector of the first transistor to the second and third transistors (Q₅,Q₆) so that, when the reference signal and the measuring signal have a same phase signal, all current passing through the first transistor (Q₂) is connected via a resistor (R₄ or R₅) to one of the input terminals for the equal voltage, which gives rise to a voltage difference between the voltage output (at B₁,B₂) via the resistor (R₁₅ and R₁₆), while for no measuring signal through the first transistor (Q₂) the second and third transistors (Q₅,Q₆) conduct currents of equal intensity alternatively from the voltage inputs, whereby the voltage difference between the voltage outputs (B₁,B₂) becomes zero.

7. Apparatus as claimed in claim 3, **characterized** in that the third detector includes a transistor (Q₁) which is fed with the measuring signal amplified by the first transistor (Q₂) via a capacitor (C₇), the measuring signal being recovered in the collector of the transistor (Q₁) shifted 180° in relation to the first transistor (Q₂) as well as two parallel transistors (Q₃,Q₄) which are supplied with reference signals with a 90° phase shift relative to the phase in the second and third transistors (Q₅,Q₆) in the second detector by the connection cable between the detectors being a quarter of a wave length, each of the parallel transistors (Q₃,Q₄) being connected by their collectors to their respective equal feed voltage via two equal resistors (R₂,R₃), the collectors also having their individual voltage outputs (F₁,F₂) via their individual resistors (R₁₃,R₁₄), the transistor (Q₁) being connected by its collector to both of the parallel transistors (Q₃,Q₄), signifying that the reference signal and the measuring signal are compared and give rise either to a voltage difference between the individual voltage outputs (F₁,F₂) or to a zero voltage difference.

8. Apparatus as claimed in claim 3, **characterized** in that the control of the three detectors by the adjusting means is carried out with the aid of an amplifier which receives and amplifies signals from the three detectors.

9. Apparatus as claimed in claim 3, **characterized** in that the electro-mechanical drive means (44) for said tuning means (41, 42) comprises a fixed, cylinder chamber (43), closed at one end, which in this end concentrically carries a cylindrical iron core (45) with a permanent magnet (46), an electricallly insulating sleeve (48) being reciprocatingly arranged about said core (45), the sleeve (48) carrying a winding in the region of said iron core, an end of the sleeve (48) opposite the closed end of the cylinder chamber (43) carrying a metal plunger (42), which is reciprocatingly arranged in the cylinder chamber (43) associated with the cavity resonator.

10. Apparatus as claimed in claim 9, **characterized** in that the metal plunger (42) is carried by the sleeve (48) via a piston rod (50) of high-frequency insulating material.

11. Apparatus as claimed in claim 9, **characterized** in that sleeve (48) contains a disc (52) adjacent the iron core (45) delimiting a damping volume for reciprocating movement of the sleeve about said iron core.

12. Apparatus as claimed in claim 9, **characterized** in that the sleeve (48) or the piston rod (50) is carried by support cushions (51) in the region of the center of gravity of the combination of metal plunger (42), sleeve (48), winding and piston rod.

13. Apparatus as claimed in claim 9, **characterized** in that the sleeve (48) is made of aluminium and the iron core (45) has a coating of teflon.

14. Method according to claim 1 for locally increasing the number of available frequencies in base stations within a given area which has been allocated a given number of frequencies, said base stations being equipped with a plurality of individual, tunable resonance modules, **characterized** in that each base station is equipped with a number of cavity resonators greater than the number corresponding to the number of necessary frequencies for normal or small telephone traffic of said base stations, wherein when a given base station needs to increase its number of frequencies due to increasing local traffic, unoccupied cavity resonators are tuned to frequencies which are not needed in at least one other base station for a period of time extending over the increase traffic intensity of the base station in question, and that the reverse takes place afterwards, whereby tuning is carried out byt the cavity resonator in question being supplied with a signal of a given frequency which will control the adjustment of the cavity resonator such that its resonance frequency will be equal to the frequency of the input signals.

## Patentansprüche

1. Verfahren zur Verwendung in mobilen Telefonsystemen, die enthalten:
eine Basisstation, die umfaßt:
- eine Mehrzahl von Resonanzmodulen in der Form von Hohlraumresonatoren zum getrennten Einstellen jedes dieser Resonanzmodule auf seine eigene Frequenz zum Empfangen und Absenden von Telefonsignalen auf dieser Frequenz,
- Abstimmittel in jedem Resonanzmodul, das in Beziehung zu der Frequenz von in das Modul eingespeisten Signalen zu einer gegebenen Resonanzposition geführt wird,
- elektromechanische Antriebsmittel zum Betreiben des Abstimmittels;
wobei für jeden der Hohlraumresonatoren
- ein spezifisches Eingangssignal zu der Basisstation als Referenzsignal verwendet wird, in die Hohlraumresonatoren eingespeist wird und zur Erkennung an dem Eingang der Hohlraumresonatoren verfügbar gemacht wird, und
- ein Meßsignal zur Erkennung an dem Ausgang des Hohlraumresonators verfügbar gemacht wird,
**dadurch gekennzeichnet,**
daß das Verfahren die Schritte umfaßt:
- Erkennen des Referenzsignals;
- Erzeugen eines ersten Steuersignals, das bei einer positiven Ausgangsspannung liegt, wenn das Referenzsignal vorhanden ist, und das Null ist, wenn das Referenzsignal nicht vorhanden ist, und das jeweils bestimmt, ob oder ob nicht das Abstimmittel mit einer Spannung versorgt wird, die das Antriebsmittel aktiviert;
- Erkennen der Amplituden des Referenzsignals und des Meßsignals, und
- falls die Amplituden nicht gleich sind und das erste Steuersignal bei der positiven Ausgangsspannung liegt, Aktivieren des Antriebsmittels in einen Suchmodus, um das Resonanzmodul über seinen Bereich von Resonanzfrequenzen abzutasten,
- falls die Amplituden vor und während dieser Abtastung gleich sind, Deaktivieren des Antriebsmittels;
- Erkennen der Phasendifferenz zwischen dem Referenz- und dem Meßsignal, und entsprechendes Erzeugen einer Spannung, die das Antriebsmittel derart reaktiviert, daß die Phase des Meßsignals zu der Phase des Referenzsignals hin geändert wird.

2. Verfahren nach Anspruch 1, in dem die Phasendifferenz zwischen dem Meßsignal und dem Referenzsignal bestimmt wird, indem entweder dem Meßsignal oder dem Referenzsignal eine Phasendifferenz von 90° verliehen wird, um ein Hilfssignal zu bilden, wobei dann, wenn die Phase zwischen dem Hilfssignal und dem Signal mit der unveränderten Phase Null ist, kein Signal gesendet wird, um das Einstellmittel anzusteuern.

3. Vorrichtung zur Verwendung in mobilen Telefonsystemen, die enthält:
eine Basisstation, die umfaßt:
- eine Mehrzahl von Resonanzmodulen in der Form von Hohlraumresonatoren zum getrennten Einstellen jedes dieser Resonanzmodule auf seine eigene Frequenz zum Empfangen und Absenden von Telefonsignalen auf dieser Frequenz,
- Abstimmittel in jedem Resonanzmodul, das in Beziehung zu der Frequenz von in das Modul eingespeisten Signalen zu einer gegebenen Resonanzposition geführt wird,
- elektromechanische Antriebsmittel zum Betreiben des Abstimmittels;
wobei für jeden der Hohlraumresonatoren
- ein spezifisches Eingangssignal zu der Basisstation als ein Referenzsignal verwendet wird, in die Hohlraumresonatoren eingespeist wird und zur Erkennung an dem Eingang der Hohlraumresonatoren verfügbar gemacht wird, und
- ein Meßsignal zur Erkennung an dem Ausgang des Hohlraumresonators verfügbar gemacht wird,
gekennzeichnet durch:
- Mittel (5) zum Erkennen des Referenzsignals;
- Mittel zum Erzeugen eines Steuersignals aus dem Referenzsignal, wobei das Steuersignal bei einer positiven Ausgangsspannung liegt, wenn das Referenzsignal vorhanden ist, und Null ist, wenn das Referenzsignal nicht vorhanden ist, und das jeweils bestimmt, ob oder ob nicht das Abstimmittel mit einer Spannung versorgt wird, die das Antriebsmittel (3) aktiviert;
- Mittel (6) zum Erkennen der Amplituden des Referenzsignals und des Meßsignals, wobei dieses Mittel derart arbeitet, daß es:
- falls die Amplituden nicht gleich sind und das Steuersignal bei der positiven Ausgangsspannung liegt, das Antriebsmittel in einen Suchmodus aktiviert, um das Resonanzmodul über seinen Bereich von Resonanzfrequenzen abzutasten,
- falls die Amplituden vor oder während dieser Abtastung gleich sind, das Antriebsmittel deaktiviert;
- Mittel (7) zum Erkennen der Phasendifferenz zwischen dem Referenz- und dem Meßsignal, und zum entsprechenden Erzeugen einer Spannung, die das Antriebsmittel derart reaktiviert, daß die Phase des Meßsignals zu der Phase des Referenzsignals hin geändert wird.

4. Vorrichtung nach Anspruch 3, dadurch gekennzeichnet, daß der dritte Detektor Mittel (Q₃, Q₄) umfaßt, um entweder das Signal von der Empfangsseite des Hohlraumresonators oder das Signal von der Übertragungsseite des Hohlraumresonators um 90° phasenzuverschieben.

5. Vorrichtung nach Anspruch 3, dadurch gekennzeichnet, daß der erste Detektor eine Diode (d₁) enthält, die mit der Empfangsseite des Hohlraumresonators verbunden ist, und einen Widerstand (R₁) und einen Kondensator (C₁) an der anderen Seite der Diode enthält, wobei der Widerstand (R₁) und der Kondensator (C₁) mit Enden an Erde angeschlossen sind.

6. Vorrichtung nach Anspruch 3, dadurch gekennzeichnet, daß der zweite Detektor enthält einen ersten Transistor (Q₂), dessen Basis über einen Koppelkondensator (C₆) mit einem Eingang des Meßsignals verbunden ist, um einen Kollektor des Transistors zu erreichen, einen zweiten Transistor (Q₆) und einen dritten Transistor (Q₅) mit Basis-Elektroden, die parallel mit einem Eingang des Referenzsignals über ein Filter (C₂, L₁) und ein kurzes Kabel verbunden sind, wobei eine gleiche Spannung parallel in Kollektoren des zweiten und dritten Transistors (Q₅, Q₆) gespeist werden, wobei eine Spannung von jedem Kollektor über einen Widerstand (R₁₅, R₁₆) abgeriffen wird, wobei der erste Transistor (Q₂) über den Kollektor des ersten Transistors mit den zweiten und dritten Transistoren (Q₅, Q₆) derart verbunden ist, daß dann, wenn das Referenzsignal und das Meßsignal ein gleiches Phasensignal aufweisen, der gesamte durch den ersten Transistor (Q₂) laufende Strom über einen Widerstand (R₄ oder R₅) mit einem der Eingangsanschlüsse für die gleiche Spannung verbunden ist, was eine Spannungsdifferenz zwischen dem Spannungsausgang (bei B₁, B₂) über dem Widerstand (R₁₅ und R₁₆) bewirkt, während dann, wenn kein Meßsignal durch den ersten Transistor (Q₂) läuft, die zweiten und dritten Transistoren (Q₅, Q₆) wechselweise von den Spannungseingängen Ströme gleicher Intensität leiten, wobei die Spannungsdifferenz zwischen den Spannungsausgängen (B₁, B₂) Null wird.

7. Vorrichtung nach Anspruch 3, dadurch gekennzeichnet, daß der dritte Detektor einen Transistor (Q₁) enthält, der von dem Meßsignal gespeist wird, das von dem ersten Transistor (Q₂) über einen Kondensator (C₇) verstärkt wird, wobei das in dem Kollektor des Transistors (Q₁) wiedererhaltene Meßsignal in Beziehung zu dem ersten Transistor (Q₂) um 180° verschoben ist, sowie zwei parallele Transistoren (Q₃, Q₄) enthält, die mit den Referenzsignalen mit einer 90°-Phasenverschiebung relativ zu der Phase in den zweiten und dritten Transistoren (Q₅, Q₆) in dem zweiten Detektor über das Verbindungskabel zwischen den Detektoren versorgt werden, was ein Viertel einer Wellenlänge ist, wobei jeder der parallelen Transistoren (Q₃, Q₄) mit seinem Kollektor über zwei gleiche Widerstände (R₂, R₃) mit seiner jeweils gleichen Speisespannung verbunden sind, wobei die Kollektoren über ihre individuellen Widerstände (R₁₃, R₁₄) auch ihre individuellen Spannungsausgänge (F₁, F₂) besitzen, wobei der Transistor (Q₁) über seinen Kollektor mit beiden der parallelen Transistoren (Q₃, Q₄) verbunden ist, was anzeigt, daß das Referenzsignal und das Meßsignal verglichen werden, und was entweder eine Spannungsdifferenz zwischen den individuellen Spannungsausgängen (F₁, F₂) oder eine Spannungsdifferenz des Wertes Null bewirkt.

8. Vorrichtung nach Anspruch 3, dadurch gekennzeichnet, daß die Steuerung der drei Detektoren durch das Einstellmittel mit der Hilfe eines Verstärkers durchgeführt wird, der Signale von den drei Detektoren empfängt und verstärkt.

9. Vorrichtung nach Anspruch 3, dadurch gekennzeichnet, daß das elektromechanische Antriebsmittel (44) für das Abstimmittel (41, 42) umfaßt eine feststehende, an einem Ende geschlossene Zylinderkammer (43) aufweist, die an diesem Ende einen zylindrischen Eisenkern (45) mit einem Permanentmagneten (46) konzentrisch trägt, eine elektrisch isolierende Buchse (48), die auf diesem Kern (45) hinund herbewegbar angeordnet ist, wobei die Buchse (48) in dem Bereich des Eisenkerns eine Wicklung trägt, und wobei ein dem geschlossenen Ende der Zylinderkammer (43) gegenüberliegendes Ende der Buchse (48) einen Metallkolben (42) trägt, der hin- und herbewegbar in der dem Hohlraumresonator zugeordneten Zylinderkammer (43) angeordnet ist.

10. Vorrichtung nach Anspruch 9, dadurch gekennzeichnet, daß der Metallkolben (42) von der Buchse (48) über eine Kolbenstange (50) aus Hochfrequenzisolationsmaterial getragen ist.

11. Vorrichtung nach Anspruch 9, dadurch gekennzeichnet, daß die Buchse (48) eine Scheibe (52) benachbart zu dem Eisenkern (45) enthält, die ein Dämpfungsvolumen für die Hin- und Herbewegung der Buchse um den Eisenkern abgrenzt.

12. Vorrichtung nach Anspruch 9, dadurch gekennzeichnet, daß die Buchse (48) oder die Kolbenstange (50) in dem Bereich des Schwerpunktes der Kombination des Metallkolbens (42), der Buchse (48), der Wicklung und der Kolbenstange von Stützkissen (51) getragen ist.

13. Vorrichtung nach Anspruch 9, dadurch gekennzeichnet, daß die Buchse (48) aus Aluminium gemacht ist und daß der Eisenkern (45) eine Beschichtung aus Teflon aufweist.

14. Verfahren nach Anspruch 1 zur örtlichen Erhöhung der Anzahl von verfügbaren Frequenzen in Basisstationen innerhalb eines gegebenen Bereichs, dem eine gegebene Anzahl von Frequenzen zugeteilt sind, wobei diese Basisstationen mit einer Mehrzahl von individuellen, abstimmbaren Resonanzmodulen ausgerüstet sind, dadurch gekennzeichnet, daß jede Basisstation mit einer Anzahl von Hohlraumresonatoren ausgestattet ist, die größer als die Anzahl ist, die der Anzahl von für einen normalen oder geringen Fernsprechbetrieb dieser Basisstationen erforderlichen Frequenzen entspricht, wobei dann, wenn eine gegebene Basisstation aufgrund zunehmendem lokalen Betrieb ihre Anzahl von Frequenzen erhöhen muß, nicht belegte Hohlraumresonatoren auf Frequenzen abgestimmt werden, die in zumindest einer anderen Basisstation für eine Zeitspanne, die sich über die Fernsprechintensitätszunahme der fraglichen Basisstation erstreckt, nicht benötigt werden, und daß danach das umgekehrte stattfindet, wobei die Abstimmung von dem fraglichen Hohlraumresonator ausgeführt wird, der mit einem Signal einer gegebenen Frequenz versorgt wird, die die Einstellung des Hohlraumresonators derart steuert, daß seine Resonanzfrequenz gleich der Frequenz der Eingangssignale ist.

## Revendications

1. Procédé destiné à être utilisé dans des systèmes de téléphone mobile qui comportent : une station de base comprenant :
- de multiples modules de résonance sous la forme de cavités résonnantes pour ajuster séparément chacun desdits modules de résonance à sa propre fréquence pour recevoir et expédier des signaux téléphoniques sur cette fréquence,
- des moyens d'accord, dans chaque module de résonance, qui sont guidés à une position de résonance donnée en fonction de la fréquence de signaux appliqués au module,
- des moyens de commande électromécaniques pour actionner les moyens d'accord,
selon lequel, pour chacune desdites cavités résonnantes :
- un signal d'entrée spécifique parvenant à la station de base est utilisé comme signal de référence, appliqué aux cavités résonnantes et rendu disponible pour une détection à l'entrée des cavités résonnantes, et
- un signal de mesure est rendu disponible pour une détection à la sortie de la cavité résonnante,
caractérisé en ce qu'il comporte les opérations consistant :
- à détecter le signal de référence,
- à produire un premier signal de commande qui est à une tension de sortie positive lorsque le signal de référence est présent et est nul lorsque le signal de référence n'est pas présent et qui détermine respectivement s'il est ou non fourni aux moyens d'accord une tension qui active lesdits moyens de commande,
- à détecter les amplitudes du signal de référence et du signal mesuré et,
- si les amplitudes ne sont pas égales et ledit premier signal de commande est à la tension de sortie positive, à activer les moyens de commande dans un mode de recherche de façon à soumettre le module de résonance à un balayage sur l'étendue de son domaine de fréquences de résonance,
- si les amplitudes sont égales avant ou pendant ledit balayage, à désactiver les moyens de commande,
- à détecter la différence de phase entre le signal de référence et le signal de mesure, et à produire d'une manière correspondante une tension réactivant les moyens de commande d'une façon telle que la phase du signal de mesure varie vers la phase du signal de référence.

2. Procédé selon la revendication 1, dans lequel la différence de phase entre le signal de mesure et le signal de référence est déterminée par le fait qu'il est donné à l'un ou l'autre du signal de mesure et du signal de référence une différence de phase de 90° de façon à former un signal auxiliaire, de sorte que, lorsque la phase entre le signal auxiliaire et le signal présentant la phase inchangée est nulle, aucun signal n'est envoyé pour commander les moyens d'accord.

3. Dispositif destiné à être utilisé dans des systèmes de téléphone mobile qui comportent : une station de base comprenant :
- de multiples modules de résonance sous la forme de cavités résonnantes pour ajuster séparément chacun desdits modules de résonance à sa propre fréquence pour recevoir et expédier des signaux téléphoniques sur cette fréquence,
- des moyens d'accord, dans chaque module de résonance, qui sont guidés à une position de résonance donnée en fonction de la fréquence de signaux appliqués au module,
- des moyens de commande électromécaniques pour actionner les moyens d'accord,
dans lequel, pour chacune desdites cavités résonnantes :
- un signal d'entrée spécifique parvenant à la station de base est utilisé comme signal de référence, appliqué aux cavités résonnantes et rendu disponible pour une détection à l'entrée des cavités résonnantes, et
- un signal de mesure est rendu disponible pour une détection à la sortie de la cavité résonnante,
caractérisé par :
- des moyens (5) pour détecter le signal de référence,
- des moyens pour produire à partir du signal de référence un signal de commande qui est à une tension de sortie positive lorsque le signal de référence est présent et est nul lorsque le signal de référence n'est pas présent et qui détermine res pectivement s'il est ou non fourni aux moyens d'accord une tension qui active lesdits moyens de commande (3),
- des moyens (6) pour détecter les amplitudes du signal de référence et du signal mesuré, lesdits moyens fonctionnant d'une façon telle que :
- si les amplitudes ne sont pas égales et ledit signal de commande est à la tension de sortie positive, à activer les moyens de commande dans un mode de recherche de façon à soumettre le module de résonance à un balayage sur l'étendue de son domaine de fréquences de résonance,
- si les amplitudes sont égales avant ou pendant ledit balayage, à désactiver les moyens de commande,
- des moyens (7) pour détecter la différence de phase entre le signal de référence et le signal de mesure, et à produire d'une manière correspondante une tension réactivant les moyens de commande d'une façon telle que la phase du signal de mesure varie vers la phase du signal de référence.

4. Dispositif selon la revendication 3, caractérisé en ce que le troisième détecteur comprend des moyens (Q₃, Q₄) servant à réaliser un déphasage de 90° soit du signal provenant du côté de réception de la cavité résonnante, soit du signal provenant du côté d'émission de la cavité résonnante.

5. Dispositif selon la revendication 3, caractérisé en ce que le premier détecteur comprend une diode (d₁) connectée au côté de réception de la cavité résonnante, et comportant un résistor (R₁) et un condensateur (C₁) de l'autre côté de la diode, le résistor (R₁) et le condensateur (C₁) ayant des extrémités connectées à la masse.

6. Dispositif selon la revendication 3, caractérisé en ce que le deuxième détecteur comprend un premier transistor (Q₂) ayant une base connectée à une entrée du signal de mesure par l'intermédiaire d'un condensateur de couplage (C₆) pour atteindre un collecteur du transistor, un deuxième transistor (Q₆) et un troisième transistor (Q₅) ayant des bases qui sont connectées en parallèle à une entrée du signal de référence par l'intermédiaire d'un filtre (C₂, L₁) et un câble de faible longueur, une tension égale étant appliquée en parallèle aux collecteurs du deuxième et du troisième transistors (Q₅, Q₆), une tension provenant de chaque collecteur étant prélevée par l'intermédiaire d'un résistor (R₁₅, R₁₆), le premieer transistor (Q₂) étant connecté par le collecteur du premier transistor au deuxième et au troisième transistors (Q₅, Q₆) d'une façon telle que, lorsque le signal de référence et le signal de mesure ont un même signal de phase, tout le courant traversant le premier transistor (Q₂) est connecté par l'intermédiaire d'un résistor (R₄ ou R₅) à l'une des bornes d'entrée pour la tension égale, ce qui donne lieu à une différence de tension entre la sortie de tension (en B₁, B₂) par l'intermédiaire du résistor (R₁₅ et R₁₆), tandis que, lorsqu'aucun signal de mesure ne traverse le premier transistor (Q₂), le deuxième et le troisième transistors (Q₅, Q₆) conduisent d'une manière alternée des courants d'intensité égale provenant des entrées de tension, de sorte que la différence de tension entre les sorties de tension (B₁, B₂) devient nulle.

7. Dispositif selon la revendication 3, caractérisé en ce que le troisième détecteur comprend un transistor (Q₁) auquel est appliqué, par l'intermédiaire d'un condensateur (C₇), le signal de mesure amplifié par le premier transistor (Q₂), le signal de mesure étant récupéré dans le collecteur du transistor (Q₁) déphasé de 180° vis-à-vis du premier transistor (Q₂), ainsi que deux transistors (Q₃, Q₄) à montage en parallèle auxquels sont appliqués des signaux de référence présentant un déphasage de 90° vis-à-vis de la phase se présentant dans le deuxième et le troisième transistors (Q₅, Q₆) du deuxième détecteur du fait que le câble de connexion entre les détecteurs a une longueur d'un quart de longueur d'onde, les transistors (Q₃, Q₄) à montage en parallèle étant connectés chacun par leurs collecteurs à leur tension égale respective d'alimentation par l'intermédiaire de deux résistors égaux (R₂, R₃), les collecteurs comportant aussi leurs sorties individuelles de tension (F₁, F₂) par l'intermédiaire de leurs résistors individuels (R₁₃, R₁₄), le transistor (Q₁) étant connecté par son collecteur à l'un et l'autre des transistors (Q₃, Q₄) à montage en parallèle, ce qui signifie que le signal de référence et le signal de mesure sont comparés et donnent lieu soit à une différence de tension entre les sorties individuelles de tension (F₁, F₂), soit à une différence de tension nulle.

8. Dispositif selon la revendication 3, caractérisé en ce que la commande des trois détecteurs à l'aide des moyens d'ajustement s'effectue au moyen d'un amplificateur qui reçoit et amplifie des signaux provenant des trois détecteurs.

9. Dispositif selon la revendication 3, caractérisé en ce que les moyens de commande électromécaniques (44) pour les moyens d'accord (41, 42) comprennent une chambre cylindrique fixe (43), fermée à une extrémité, qui, à cette extrémité, porte suivant le même axe un noyau de fer cylindrique (45) comportant un aimant permanent (46), un manchon électriquement isolant (48) étant disposé autour du noyau (45) de façon à pouvoir être déplacé dans un sens et dans l'autre, le manchon (48) portant un enroulement dans la zone du noyau de fer, tandis qu'une extrémité du manchon (48) située à l'opposé de l'extrémité fermée de la chambre cylindrique (43) porte un plongeur métallique (42) qui est disposé de façon à pouvoir être déplacé dans un sens et dans l'autre dans la chambre cylindrique (43) associée à la cavité résonnante.

10. Dispositif selon la revendication 9, caractérisé en ce que le plongeur métallique (42) est porté par le manchon (48) par l'intermédiaire d'une tige de piston (50) en matière isolante vis-à-vis des hautes fréquences.

11. Dispositif selon la revendication 9, caractérisé en ce que le manchon (48) contient un disque (52), adjacent au noyau de fer (45), qui délimite un volume d'amortissement pour un déplacement du manchon dans un sens et dans l'autre autour du noyau de fer.

12. Dispositif selon la revendication 9, caractérisé en ce que le manchon (48) ou la tige de piston (50) est porté par des coussins de support (51) dans la zone du centre de gravité de la combinaison du plongeur métallique (42), du manchon (48), de l'enroulement et de la tige de piston.

13. Dispositif selon la revendication 9, caractérisé en ce que le manchon (48) est en aluminium et le noyau de fer (45) présente un revêtement de Téflon.

14. Procédé selon la revendication 1, permettant d'augmenter localement le nombre de fréquences disponibles dans des stations de base dans les limites d'une aire donnée à laquelle ont été allouées un nombre donné de fréquences, lesdites stations de base étant équipées de multiples modules individuels de résonance agencés de façon à pouvoir être accordés, caractérisé en ce que chaque station de base est équipée d'un nombre de cavités résonnantes supérieur au nombre correspondant au nombre de fréquences nécessaires pour un trafic téléphonique des stations de base qui est normal ou faible, en ce que, lorsqu'une station de base donnée a besoin d'augmenter son nombre de fréquences en raison d'une augmentation de trafic local, des cavités résonnantes non occupées sont accordées à des fréquences qui ne sont pas nécessaires dans au moins une autre station de base, pendant une période de temps couvrant l'intensité accrue de trafic de la station de base en question et en ce que c'est l'inverse qui se produit ensuite, l'accord étant réalisé par le fait qu'il est appliqué à la cavité résonnante en question un signal d'une fréquence donnée qui commande l'ajustement de la cavité résonnante d'une façon telle que sa fréquence de résonance soit égale à la fréquence des signaux d'entrée.
